(19) Europäisches Patentamt
European Patent Office
Office européen des brevets

(11) **EP 2 237 079 B1**

(12) **EUROPÄISCHE PATENTSCHRIFT**

(45) Veröffentlichungstag und Bekanntmachung des Hinweises auf die Patenterteilung:
**29.05.2013 Patentblatt 2013/22**

(51) Int Cl.:
***G02B 3/00*** *(2006.01)*     ***G02B 27/09*** *(2006.01)*

(21) Anmeldenummer: **09004991.7**

(22) Anmeldetag: **03.04.2009**

(54) **Vorrichtung zum Homogenisieren kohärenter Strahlung**

Device for homogenising coherent radiation

Dispositif d'homogénéisation d'un rayonnement cohérent

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**06.10.2010 Patentblatt 2010/40**

(73) Patentinhaber: **Innovavent GmbH**
**37085 Göttingen (DE)**

(72) Erfinder: **Schmidt, Henning, Dr.**
**37083 Göttingen (DE)**

(74) Vertreter: **von Hellfeld, Axel**
**Wuesthoff & Wuesthoff**
**Patent- und Rechtsanwälte**
**Schweigerstrasse 2**
**81541 München (DE)**

(56) Entgegenhaltungen:
EP-A- 1 793 269     WO-A-2007/141185
WO-A-2008/043491     DE-A1- 19 751 106
US-A1- 2007 116 079     US-B1- 6 393 042

**Beschreibung**

Die Erfindung betrifft eine optische Vorrichtung zum Homogenisieren kohärenten Lichts, insbesondere zum Homogenisieren von Laserstrahlung.

Der Begriff "Licht" soll hier umfassend als elektromagnetische Strahlung verstanden werden, also insbesondere auch nicht sichtbare Wellenlängen des elektromagnetischen Spektrums enthalten. Insbesondere betrifft die Erfindung Strahlung, wie sie mit frequenzverdoppelten Festkörperlasern erzeugt werden kann. Wie dem Fachmann auf dem Gebiet der Optik bekannt, kann die Verteilung der Strahlung in Raum und Zeit durch eine Amplitude a(r, t) und eine Phase $\varphi$ ($\vec{r}$, t) als eine komplexwertige Amplitude $A(\vec{r}, t) = a(\vec{r}, t) e^{i \varphi(\vec{r}, t)}$ (hier ohne Berücksichtung eines Polarisationszustands des Lichts) beschrieben werden. "Kohärentes Licht" ist durch eine Korrelation der Phase $\varphi(\vec{r}, t)$ in einem durch die Anwendung bestimmten räumlichen oder zeitlichen Umfang gekennzeichnet.

Von einem Laser emittierte Strahlung ist ein bedeutender Anwendungsfall kohärenten Lichts. Anwendungsabhängig sind auch Monochromatik oder eine hohe Leistung bezogen auf eine Fläche im Querschnitt der Strahlung bedeutende Strahlungseigenschaften. Die Leistung ist dem Betragsquadrat $|A(\vec{r}, t)|^2$ der Amplitude proportional und wird im zeitlichen Mittel als Intensität der Strahlung bezeichnet. Zu den Anwendungen gehört beispielsweise das Kristallisieren von dünnen Siliziumschichten. Diesen Einsatz betrifft insbesondere die vorliegende Erfindung. Hierzu ist für gleichbleibende Bohrungstiefe, Durchmesser oder Kantenqualität eine gleichmäßige Verteilung der Intensität im Querschnitt der Strahlung notwendig. Auch erfordern beispielsweise Anwendungen in Maskenprojektionsverfahren eine gleichmäßige Intensitätsverteilung.

Laserstrahlung weist häufig eine ungleichmäßige Intensitätsverteilung auf, was als "inhomogenes Strahlprofil" bezeichnet wird. Dies gilt für eine Vielzahl von Laserquellen. So hat z.B. die von vielen Lasertypen emittierte Strahlung in Richtung einer ersten Achse ein sog. Gauß-Profil, während die Intensitätsverteilung senkrecht dazu etwa trapezförmig ist. Auch die Ausbreitung der Strahlung kann deren Intensitätsverteilung beeinflussen. So wird z.B. das Gauß-Profil bei Ausbreitung im freien Raum forminvariant aufgeweitet.

"Homogenisieren" bezeichnet ein optisches Abbilden von Strahlung mit ungleichmäßiger Intensitätsverteilung zum Erhalt von Strahlung mit im Wesentlichen gleichmäßiger Intensitätsverteilung. Die Druckschrift DE 42 20 705 C2 beschreibt die Grundform einer derartigen optischen Abbildung, von der auch die vorliegende Erfindung ausgeht. Dort wird eine Vorrichtung mit einem eingangsseitigen "Linsenarray" beschrieben. Das Linsenarray ist eine periodische Anordnung mehrerer Linsen in einer Ebene, die senkrecht zur Ausbreitungsrichtung einer einfallenden Strahlung steht. Ausgangsseitig ist hinter dem Linsenarray zumindest eine Sammellinse im Strahlengang angeordnet. Von jeder Linse des Linsenarrays gehen jeweils zwei Teilstrahlen aus. Die Gesamtheit der Teilstrahlen wird so überlagert, dass die von der Sammellinse abgebildete Strahlung weitgehend homogenisiert, d.h. räumlich angeglichen ist.

Eine Weiterbildung einer derartigen optischen Vorrichtung zum Homogenisieren findet sich in der Druckschrift DE 102 25 674 A1. Dort sind zwei Linsenarrays hintereinander im Strahlengang angeordnet, wobei das hintere Linsenarray aus zwei Subarrays zusammensetzt ist. Dies ergibt eine periodische Anordnung mehrerer Linsen in insgesamt drei Ebenen, die jeweils senkrecht zur Ausbreitungsrichtung der eingangsseitig einfallenden Strahlung stehen.

Bei Nutzung kohärenter Strahlungsquellen treten jedoch aufgrund der Periodizität der Linsenanordnung Interferenzmuster in der ausgangsseitigen Intensitätsverteilung auf, die die Homogenität verschlechtern.

Die Druckschrift "Fraunhofer IOF Jahresbericht 2007" beschreibt auf den Seiten 46 und 47, wie durch eine keilförmige Anordnung die Periodizität der Linsenanordnung durchbrochen werden kann zur Verbesserung der Homogenität der ausgangsseitig erhaltenen Intensitätsverteilung. Jedoch können Interferenzeinflüsse verbleiben und die Intensitätsverteilung kann in Keilrichtung durch die keilförmige Linsenanordnung variieren. Die Druckschrift "Photonik 3/2006" beschreibt auf den Seiten 76 bis 79 einen Einsatz von Streuscheiben im Strahlengang zur Reduzierung der durch die periodische Linsenanordnung verursachten Interferenzmuster. Je nach Herstellungsverfahren weisen die Streuscheiben stochastische Oberflächenstrukturen auf, die einfallendes Licht in einen vorbestimmten Raumwinkel gleichmäßig streuen. Ein Nachteil des Einsatzes von Streuscheiben sind die teilweise hohen Leistungsverluste.

Die Druckschrift DE 197 51 106 A1 beschreibt einen Laserdrucker, der entlang einer optischen Achse folgende Elementgruppen umfasst: ein in mehrere Strahlungsquellensegmente (Laserdioden) aufgeteiltes Laserdioden-Array als Lichtquelle; ein Laserlinsenanordnungselement, das in mehrere den Strahlungsquellensegmenten zugeordnete Laserlinsen aufgeteilt ist; ein Fliegenaugenintegrator, der eine Vielzahl von in einer Ebene senkrecht zur optischen Achse abschnittsweise periodisch angeordnete, sphärische Linsen, eine erste und eine zweite Bildfeldlinse aufweist; eine Drucklinse; einen Modulator und eine Medienebene. Das von dem Laserdioden-Array ausgehende Licht ist über die Gesamtzahl der Strahlungsauellensegmente inkohärent. Diese Druckschrift beschreibt nicht das Homogenisieren von Lichtstrahlung mit mehreren, in sich kohärenten und zueinander paarweise inkohärenten Strahlenbündeln. Der Fliegenaugenintegrator umfasst neben der Vielzahl der abschnittsweise periodisch angeordnete, sphärische Linsen, auch die erste und die zweite Bildfeldlinse. Daher beschreibt diese Druckschrift nicht eine Vorrichtung mit nur einer abschnittsweise periodischen Linsenanordnung und einem Kondensor.

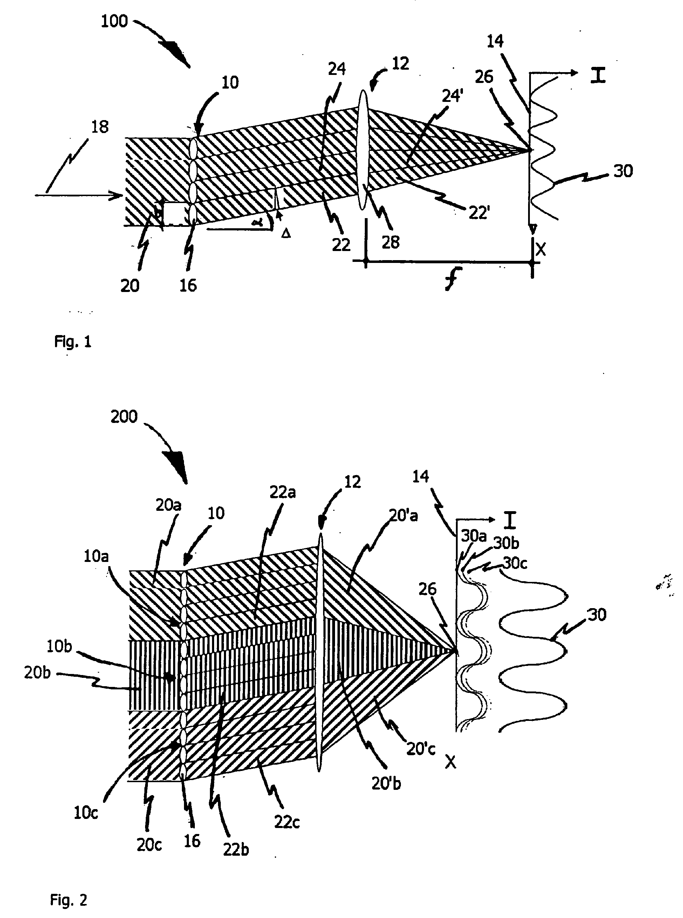

Der vorstehend zitierte Stand der Technik wird nachfolgend als bekannt vorausgesetzt. Fig. 1 zeigt schematisch ein dementsprechendes Grundprinzip einer optischen Vorrichtung zum Homogenisieren von Laserstrahlung mit einer periodischen Linsenanordnung 10 und einem Kondensor 12. In Fg. 1 fällt die Laserstrahlung von links auf die periodische Linsenanordnung. Von einzelnen Linsen in der Linsenanordnung gehen jeweils Teilstrahlenbündel hinter der periodischen Linsenanordnung unter verschiedenen Austrittswinkeln aus, von denen Fig. 1 zur Übersichtlichkeit nur jeweils einen Austrittswinkel $\alpha$ zeigt. In Abhängigkeit vom Austrittswinkel kommt es zu einem Gangunterschied $\Delta$ zwischen benachbarten Teilstrahlenbündeln. Der Kondensor bildet die einzelnen Teilstrahlenbündel in Abhängigkeit des Austrittswinkels auf ein Beleuchtungsfeld 14 ab, wo es zur Interferenz der Strahlenbündel kommt. Die Interferenz führt zu einem die Homogenisierung des Strahlprofils störenden Interferenzmuster, dessen Entstehung der dem Fachmann auf dem Gebiet der Optik bekannten Beugung am Gitter ähnelt.

Der Erfindung liegt die Aufgabe zugrunde, eine optische Vorrichtung der eingangs genannten Art so weiterzubilden, dass sie störende Interferenzmuster ohne hohe Leistungsverluste verringert.

Diese Aufgabe wird durch eine Vorrichtung zum Homogenisieren von Lichtstrahlung mit einer vorgegebenen Wellenlänge und mit den Merkmalen des Patentanspruchs 1 gelöst. Demnach umfasst die Vorrichtung eine periodische Linsenanordnung mit mehreren Linsen in wenigstens einer Ebene, die im Wesentlichen senkrecht zu einer Einfallsrichtung der Lichtstrahlung steht, und einen Kondensor, der angeordnet ist, von der periodischen Linsenanordnung ausgehende Strahlen in ein einem einer Brennweite des Kondensors entsprechenden Abstand angeordnetes Beleuchtungsfeld abzubilden. Die periodische Linsenanordnung weist mehrere Abschnitte zum Einfall jeweils eines von mehreren Strahlenbündeln mit der vorgegebenen Wellenlänge auf und ist in den Abschnitten bezüglich der Linsen periodisch ausgebildet. D, Kondensor ist ausgebildet, die mehreren Strahlenbündel mit einem lateralen Versatz auf das Beleuchtungsfeld abzubilden. Der Versatz ist so bemessen, dass durch Beugung der mehreren Strahlenbündel an der periodischen Linsenanordnung verursachte Intensitätsmodulationen sich wechselseitig im Wesentlichen kompensieren.

Fällt jeweils einer der mehreren Strahlenbündel in je einen der Abschnitte, so kann die Vorrichtung die Strahlenbündel gegeneinander versetzt auf das Beleuchtungsfeld abbilden. Dabei können die einzelnen Strahlenbündel homogenisiert werden und zudem können die Interferenzmodulationen so versetzt überlagert werden, dass sich "Täler" und "Spitzen" der Interferenzmodulationen in der Summe im Wesentlichen ausgleichen. Je höher eine Anzahl der mehreren Strahlenbündel, umso gleichmäßiger kann die Vorrichtung die Lichtstrahlung homogenisieren.

Zur Verminderung von Leistungsverlusten in Randbereichen der Abschnitte können die mehreren Abschnitte der periodischen Linsenanordnung lateral beabstandet werden.

Für eine möglichst gleichmäßige Gesamtintensität kann der laterale Versatz im Wesentlichen gleich P/N sein, wenn durch Beugung verursachte Intensitätsmodulationen eine laterale Periodizität P aufweisen und N die Anzahl der mehreren Strahlenbündel ist.

In einer ersten Ausführungsform kann der Kondensor wenigstens eine in mehrere Teile unterteilte Kondensorlinse umfassen und jeder Teil kann zum versetzten Abbilden je eines der mehreren Strahlenbündel angeordnet sein.

Zur Bestimmung des Versatzes können die Teile der unterteilten Kondensorlinse lateral beabstandet sein und/oder zueinander geneigt stehen. Die Neigung kann durch Drehen der Teile aus einer zur Einfallrichtung senkrechten Ebene entstanden sein.

In einer zweiten Ausführungsform kann im Strahlengang einer Teilzahl der mehreren Strahlenbündel jeweils eine planparallele Platte hinter dem Kondensor angeordnet sein.

Zur Bestimmung des Versatzes können die planparallelen Platten zueinander geneigt stehen. Die Neigung kann durch Drehen der planparallelen Platten aus einer zur Einfallrichtung senkrechten Ebene entstanden sein.

Zur Vermeidung von Interferenz zwischen den mehreren Strahlenbündeln kann die Vorrichtung mehrere Lichtquellen umfassen, wobei jede Lichtquelle ausgebildet ist, jeweils einen der mehreren Strahlenbündel zu erzeugen. Zur Erzeugung in sich kohärenter Strahlenbündel sind Laser und/oder Laserdioden als die Lichtquellen einsetzbar. Insbesondere können mehrere Excimerlaser als die Lichtquellen einsetzt sein.

Zur vereinfachten Erzeugung der mehreren Strahlenbündeln kann die Vorrichtung ferner einen Lichtleiter zur Aufnahme der Lichtstrahlung umfassen, wobei der Lichtleiter Auskopplungspunkte umfasst jeweils zum Auskoppeln eines der mehreren Strahlenbündel, und wobei optische Weglängen zwischen den Auskopplungspunkten größer sind als eine Kohärenzlänge der Lichtstrahlung. Damit sind zueinander paarweise inkohärente Strahlenbündel aus einer oder wenigen kohärenten Lichtquellen erzeugbar.

Zur günstigen Herstellung des Kondensor kann dieser zumindest eine Sammellinse umfassen.

Nachfolgend wird die Erfindung anhand der Zeichnungen näher erläutert. Es zeigen:

Fig. 1    schematisch ein Linsensystem zum Homogenisieren eines kohärenten Strahlenbündels gemäß dem Stand der Technik;

Fig. 2    eine erste Weiterbildung des Linsensystems aus Fig. 1 zum Homogenisieren mehrerer jeweils kohärenter Strahlenbündel;

Fig. 3    ein erstes Ausführungsbeispiel einer Vorrichtung zum Homogenisieren von Lichtstrahlung gemäß der Erfindung;

Fig. 4    ein zweites Ausführungsbeispiel einer Vorrichtung zum Homogenisieren von Lichtstrahlung gemäß der Erfindung;

Fig. 5    eine schematische Darstellung beugungsbedingter Intensitätsmodulationen und deren Überlagerung unter Verwendung von drei Lasern;

Fig. 6    eine schematische Darstellung beugungsbedingter Intensitätsmodulationen und deren Überlagerung unter Verwendung von zwei Lasern;

Fig. 7    eine schematische Darstellung eines Beleuchtungsfelds unter Verwendung von zwei Lasern bei einer ersten periodischen Linsenanordnung;

Fig. 8    eine schematische Darstellung des Beleuchtungsfelds unter Verwendung von zwei Lasern bei einer zweiten periodischen Linsenanordnung; und

Fig. 9    eine schematische Darstellung eines Lichtleiteraufbaus zum Erzeugen von drei zueinander paarweise inkohärenten Strahlenbündeln unter Verwendung eines Laser.

Fig. 1 zeigt ein allgemein mit 100 bezeichnetes Linsensystem gemäß dem Stand der Technik. Das Linsensystem 100 umfasst eingangsseitig eine periodische Linsenanordnung 10 und ausgangsseitig einen Kondensor 12. Der Kondensor 12 ist im Strahlengang hinter der periodischen Linsenanordnung 10 derart angeordnet, dass von der periodischen Linsenanordnung 10 ausgehende parallele Strahlenbündel in ein Beleuchtungsfeld 14 fokussiert werden. Dazu sind Kondensor 12 und Beleuchtungsfeld 14 in einem einer Brennweite f des Kondensors 12 entsprechenden Abstand angeordnet.

Die periodische Linsenanordnung 10 umfasst mehrere Sammellinsen 16, die in einer im Wesentlichen senkrechten Ebene zur Ausbreitungsrichtung 18 eines in Fig. 1 von links einfallenden kohärenten Strahlenbündels 20 mit Wettenlänge $\lambda$ angeordnet sind. Der Einfachheit halber zeigt die periodische Linsenanordnung 10 in Fig. 1 nur vier Sammellinsen 16 in einer Ebene. Meist werden 10 bis 20, nicht selten auch bis zu 100 Linsen je Ebene und mehrere solche im Strahlengang parallel hintereinander angeordnete Ebenen als periodische Linsenanordnung eingesetzt. Der Austrittswinkel $\alpha$ ist in diesem Fall der Austrittswinkel hinter der letzten Linsenebene bezogen auf die Ausbreitungsrichtung 18. Entsprechend umfasst der Begriff der "periodischen Linsenanordnung" nicht nur ebene Anordnungen sondern allgemein räumliche Anordnungen. Ferner können statt der dargestellten bikonvexen Sammellinsen 16 auch plankonvexe Sammellinsen in der periodischen Linsenanordnung 10 eingesetzt werden.

Von den durch das einfallende kohärente Strahlenbündel 20 beleuchteten Sammellinsen 16 geht wiederum kohärente Lichtstrahlung unter verschiedenen Austrittswinkein $\alpha$ aus. Zur besseren Übersicht sind in Fig. 1 nur Teilstrahlenbündel eines einzigen Austrittswinkels $\alpha$ eingezeichnet. Die nachfolgenden Ausführungen gelten prinzipiell für beliebige Austrittswinkel $\alpha$.

Von jeder beleuchteten Sammellinse 16 geht ein Teilstrahlenbündel 22 aus. In Abhängigkeit vom Austrittswinkel $\alpha$ kommt es zu einem Gangunterschied $\Delta$ zwischen benachbarten Teilstrahlenbündeln 22, 24. Wie der Fachmann auf dem Gebiet der Optik aus der geometrischen Anordnung unmittelbar entnimmt, besteht zwischen dem Gangunterschied $\Delta$ und dem Austrittswinkel $\alpha$ der Zusammenhang

$$\Delta = b \sin \alpha , \qquad\qquad (1)$$

wobei b eine laterale Breite der Sammellinse 16 bezeichnet. Die Teilstrahlenbündel 22, 24 werden vom Kondensor 12 in konvergente Teilstrahlenbündel 22', 24' abgebildet, die sich in einem Fokuspunkt 26 im Beleuchtungsfeld 14 überlagern. Eine Position x des Fokuspunktes 26 ist durch die Brennweite f des Kondensors 12 und den Austrittswinkel $\alpha$ gemäß

$$x = f \tan \alpha \qquad\qquad (2)$$

gegeben. In Fig. 1 ist der Kondensor 12 vereinfachend als eine Sammellinse 28 mit Brennweite f dargestellt. Der Kondensor 12 kann auch aus einem System mehrerer Kondensorlinsen bestehen, in welchem Fall die Brennweite f dessen Gesamtbrennweite bezeichnet.

Durch die Überlagerung der Teilstrahlenbündel 22', 24' mit Gangunterschied $\Delta$ kommt es im Fokuspunkt 26 zu konstruktiver oder destruktiver Interferenz. Die konstruktive Interferenz, d.h. eine Intensitätsverstärkung, ist maximal, falls der Gangunterschied $\Delta$ ein ganzzahliges Vielfaches der Wellenlänge $\lambda$ des einfallenden kohärenten Strahlenbündels 20 ist. Die destruktive Interferenz, d.h. eine Intensitätsabschwächung, führt zur Auslöschung der Intensität I falls der Gangunterschied $\Delta$ ein halbzahliges Vielfaches der Wellenlänge $\lambda$ ist (ohne ein ganzzahliges Vielfaches zu sein). Für kleine Austrittswinkel $\alpha$ stimmen Sinus- und Tangens-Funktion hinreichend genau überein (sog. Paraxialnäherung), so dass nach den Gleichungen (1) und (2) der Gangunterschied $\Delta$ mit der Position x auf dem Beleuchtungsfeld 14 gemäß

$$\Delta = x\, b/f \hspace{4cm} (3)$$

variiert, wodurch es im Beleuchtungsfeld 14 aufgrund abwechselnder konstruktiver und destruktiver Interferenz zu einer periodischen Modulation 30 der Intensität I(x) kommt.

So entsteht im Linsensystem 100 gemäß dem Stand der Technik eine die Homogenisierung des einfallenden Strahlenbündels 20 störende Intensitätsmodulation 30 durch Beugung des einfallenden kohärenten Strahlenbündels 20 an der periodischen Linsenanordnung 106.

Fig. 2 zeigt ein allgemein mit 200 bezeichnetes Linsensystem, das ebenfalls eine periodische Linsenanordnung 10, einen Kondensor 12 und ein Beleuchtungsfeld 14 umfasst. Die periodische Linsenanordnung 10 weist drei Abschnitte 10a, 10b, 10c zum getrennten Einfall von drei jeweils in sich kohärenter Strahlenbündel 20a, 20b, 20c auf. Zwischen den in sich kohärenten Strahlenbündeln 20a, 20b, 20c besteht keine signifikante Phasenkorrelation, d.h. die einzelnen Strahlenbündel 20a, 20b, 20c sind zueinander paarweise inkohärent.

Bei Beleuchtung der periodischen Linsenanordnung 10 durch die einfallenden Strahlenbündeln 20a, 20b, 20c gehen wie beim Linsensystem 100 von jeder Unse 16 der periodischen Linsenanordnung 10 Teilstrahlenbündel 22a, 22b, 22c aus. Die einzelnen Teilstrahlenbündel 22a, 22b, 22c gehen von den entsprechenden Strahlenbündeln 20a, 20b, 20c aus und weisen insbesondere deren Kohärenzeigenschaften auf. Der Kondensor 12 bildet alle Teilstrahlenbündel 22a des Strahlenbündels 20a in einen konvergenten Strahlenbündel 20'a ab, der im Fokuspunkt 26 mit den anderen konvergenten Strahlenbündeln 20'b, 20'c der entsprechenden, in sich kohärenten Strahlenbündel 20b, 20c überlagert wird. Die einzelnen, in sich kohärenten Strahlenbündel 20a, 20b, 20c tragen mit einer Intensität I(x) zur Beleuchtung des Beleuchtungsfelds 14 bei. Wie im Linsensystem 100 der Fig. 1 weist jedes in sich kohärente Strahlenbündel 20a, 20b, 20c bei der Abbildung in das Beleuchtungsfeld 14 eine Intensitätsverteilung I(x) mit periodischen Intensitätsmodulationen 30a, 30b, 30c auf. Da die in sich kohärenten Strahlenbündel 20a, 20b, 20c zueinander paarweise inkohärent sind, kommt es bei der Überlagerung der konvergenten Strahlenbündel 20'a, 20'b, 20'c im Punkt 26 zu keiner weiteren Interferenz, womit sich die periodischen Intensitätsmodulationen 30a, 30b, 30c der einzelnen kohärenten Strahlenbündel 20a, 20b, 20c zu einer periodischer Gesamtintensität 30 additiv überlagern.

Somit werden die störenden periodischen Intensitätsmodulationen 30a, 30b, 30c bei einer Beleuchtung mittels mehrerer zueinander paarweise inkohärenter Strahlenbündel 20a, 20b, 20c im Linsensystem 200 gegenüber dem konventionellen Linsensystem 100 sogar noch entsprechend der Anzahl der einfallenden Strahlenbündel 20a, 20b, 20c verstärkt.

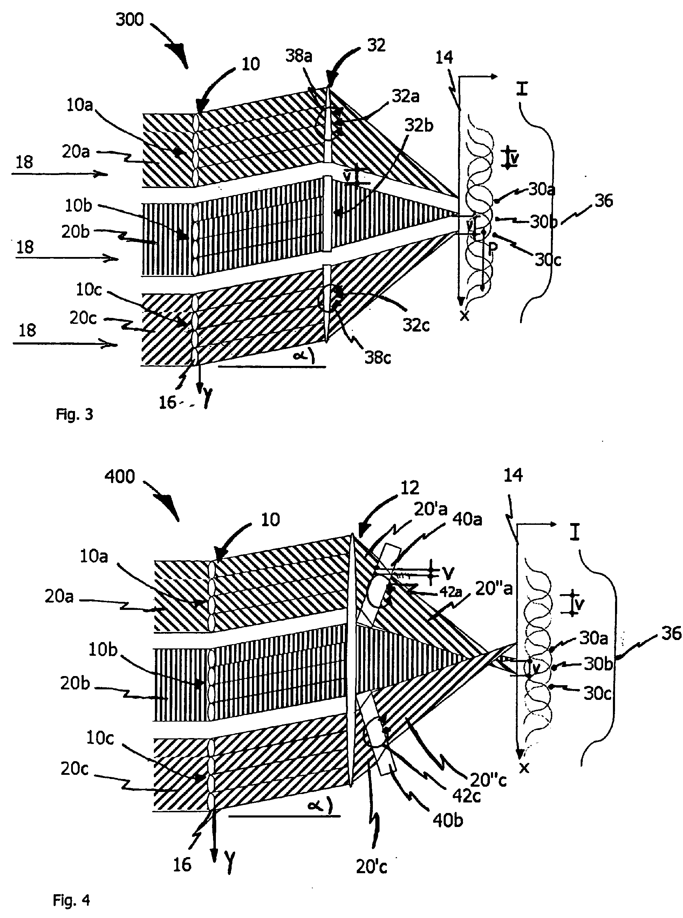

Fig. 3 zeigt ein erstes Ausführungsbeispiel einer Vorrichtung 300, welche geeignet ist, mehrerer einfallender kohärenter Strahlenbündel 20a, 20b, 20c mit inhomogenem Strahlprofil mittels einer periodischen Linsenanordnung 10 zu homogenisieren und zugleich beugungsbedingte Intensitätsmodulationen 30a, 30b, 30c zu reduzieren. Dazu weist die Vorrichtung 300 einen Kondensor auf mit einer der Anzahl zuein ander paarweise inkohärenter Strahlenbündel 20a, 20b, 20c entsprechend geteilten Kondensorlinse 32 mit (lateralen) Teilen 32a, 32b, 32c. Die einzelnen Teile 32a, 32b, 32c der geteilten Kondensorlinse 32 sind um einen lateralen Versatz V beabstandet, dem auch eine Verschiebung der einzelnen Intensitätsmodulationen 30a, 30b, 30c im Beleuchtungsfeld 14 entspricht. Der Versatz V ist so gewählt, dass ein "Tal" der Intensitätsmodulation 30a durch entsprechend versetzte Intensitätsmodulationen 30b und 30c in der Summe ausgeglichen wird. Da die Intensitätsmodulationen 30a, 30b, 30c von einheitlicher Periodizität P sind, wird so über das gesamte Beleuchtungsfeld 14 eine im Wesentlichen konstante Gesamtintensität 36 erreicht.

Das Ausführungsbeispiel der Vorrichtung 300 kann wie in Fig. 3 gezeigt, dahingehend weitergebildet werden, dass auch die einzelnen Abschnitte 10a, 10b, 10c der periodischen Linsenanordnung 10 dem lateralen Versatz V im Wesentlichen entsprechend beabstandet sind. Durch einen solchen (lateral) getrennten Aufbau können Verluste in Randbereichen der Abschnitte 10a, 10b, 10c oder der Teile 32a, 32b, 32c verringert werden.

In einer Weiterbildung der Vorrichtung 300 können die einzelnen Teile 32a, 32b, 32c der Kondensorlinse 32 in einer Drehrichtung 38 gegenüber einer Ebene senkrecht zur Ausbreitungsrichtung 18 der einfallenden Strahlenbündel 20a, 20b, 20c geneigt sein. Die einzelnen Intensitätsmodulationen 30a, 30b, 30c sind in Abhängigkeit von der Neigung gegeneinander um einen Versatz V' verschiebbar. Alternativ oder in Ergänzung zur Neigung der Teile 32a, 32b, 32c der Kondensorlinse 32 können die Abschnitte 10a, 10b, 10c oder die Teile 32a, 32b, 32c zueinander beabstandet sein.

Fg. 4 zeigt ein zweites Ausführungsbeispiel einer Vorrichtung 400 zum Homogenisieren inhomogener Strahlprofile kohärenter Strahlenbündel 20a, 20b, 20c, die zueinander paarweise inkohärent sind. Das Homogenisieren erfolgt wiederum durch eine periodische Linsenanordnung 10, wie für die Vorrichtung 300 zuvor beschrieben. Die periodische Linsenanordnung 10 kann optional einzelne Abschnitte 10a, 10b, 10c aufweisen, die gegeneinander beabstandet sind. Im Strahlengang der äußeren kohärenten Strahlenbündel 20'a, 20'c sind (zumindest im eingesetzten Wellenlängenbereich transparente) planparallele Platten 40a, 40b angeordnet. Wie dem Fachmann auf dem Gebiet der Optik bekannt, kommt es aufgrund eines von der Umgebung verschiedenen Brechungsindexes n der planparallelen Platten 40a, 40b zu einem lateralen Versatz V bei nicht senkrechtem Einfall der Strahlenbündel 20'a, 20'c auf die planparallelen Platten 40a, 40b. Aus den planparallelen Platten 40a, 40b austretende Strahlenbündel 20"a, 20"c sind gegenüber den Strahlenbündeln 20'a, 20'c um den lateralen Versatz V verschoben. Durch Drehung der planparallelen Platten 40a, 40b in Richtung 42a bzw. 42c ist der Versatz V bestimmbar. Da die Strahlenbündel 20a, 20b, 20c zueinander paarweise inkohärent sind, überlagern sich ihre Intensitätsmodulationen 30a, 30b, 30c additiv. Durch eine entsprechende Wahl des Versatzes V, wie oben in Bezug auf die Vorrichtung 300 beschrieben, ist eine resultierende Gesamtintensität 36 im Wesentlichen konstant. Somit ist nicht nur das inhomogene Strahlprofil der einfallenden Strahlenbündel 20a, 20b, 20c durch die periodische Linsenanordnung 10 homogenisiert, sondern auch die durch Beugung an der periodischen Linsenanordnung 10 verursachten Intensitätsmodulationen 30a, 30b, 30c weitgehend reduziert.

Das konventionelle Linsensysteme 100 wie auch die Vorrichtungen 300, 400 zur Homogenisierung unterliegen näherungsweise den Gesetzmäßigkeiten der Fourier-Optik. Dazu gehört die folgende Dualitätsrelation. Einerseits werden eingangsseitige Teilstrukturen des inhomogenen Strahlprofils mit Strukturabmessungen kleiner als eine Einzellinse des Linsenarrays auf das ausgangsseitige Beleuchtungsfeld 14 aufgeweitet und dadurch geglättet. Verknappt formuliert: Eine kleine eingangsseitige Struktur führt zu einer großen ausgangsseitigen Struktur. Andererseits führt die periodische Struktur des Linsenarrays zu einer Interferenzmodulation, deren Periodizität kleiner ist als das ausgangsseitige Beleuchtungsfeld 14. Entsprechend verknappt formuliert: Eine große periodische eingangsseitige Struktur führt zu einer kleinen periodischen ausgangsseitigen Struktur.

Die Homogenisierung durch Linsenarrays nach dem Stand der Technik nutzt den erstgenannten Abbildungseffekt. Dazu genügt es, von strahlenoptischen (nicht Fourier-optischen) Überlegungen auszugehen. Strahlenoptische Überlegungen übersehen jedoch den unvermeidlichen zweitgenannten Beugungseffekt. Diesem Beugungseffekt begegnet die vorliegende Erfindung.

Für eine detailliertere Betrachtung einer Wirkungsweise werden im Folgenden die Intensitätsmodulationen 30a, 30b, 30c durch das Fraunhofer'sche Beugungsintegral

$$
\begin{aligned}
A_{14}(x) &= \int A_{10}(y)\ e^{-2\pi i \Delta(x,y)/\lambda}\ dy\\
&= \int A_{10}(y)\ e^{-2\pi i y\, \sin\alpha(x)/\lambda}\ dy\\
&= \int A_{10}(y)\ e^{-2\pi i y\, x/(\lambda f)}\ dy \qquad\qquad (4)\\
&= \tilde{A}_{10}\left(\frac{2\pi x}{\lambda f}\right)
\end{aligned}
$$

näherungsweise beschrieben, wobei $A_{10}(y)$ die komplexwertige Amplitude einer hinter der periodischen Linsenanordnung 10 in der Vorrichtungen 300 oder 400 austretenden Lichtstrahlung ist und $\tilde{A}_{10}$ die Fourier-Transformierte der Amplitude $A_{10}$ ist. Genauer bezeichnet $A_{10}(y)$ die komplexwertige Amplitude der Lichtstrahlung in einer (nicht gezeigten) Brennebene hinter der Linsenanordnung 10. Entsprechend bezeichnet $A_{14}(x)$ die komplexwertige Amplitude der Lichtstrahlung im Beleuchtungsfeld 14. Die Integration in Gleichung (4) erstreckt sich entlang der in den Fign. 3 und 4 eingezeichneten y-Achse für jeweils einen der Abschnitte 10a, 10b, 10c der periodischen Linsenanordnung 10.

Die komplexwertige Amplitude $A_{10}$ hinter der periodischen Linsenanordnung 10 resultiert näherungsweise aus einer Faltung einer Amplitude $A_{20}$ eines der einfallenden kohärenten Strahlenbündel 20a, 20b oder 20c mit einer Abbildungsfunktion L(y) (eines vom Strahlenbündel beleuchteten Abschnitts 10a, 10b oder 10c) der periodischen Linsenanordnung 10:

$$A_{10} = A_{20} * L, \qquad (5)$$

wobei ein Stern (*) das Faltungsprodukt zwischen Funktionen symbolisiert. Beispielsweise ist für das Gauß-Profil eine entsprechende laterale Amplitudenverteilung des einfallenden kohärenten Strahlenbündels 20a, 20b bzw. 20c (abgesehen von konstanten Vorfaktoren) von der Form:

$$A_{20}(y) \propto e^{-(y/\sigma_{20})^2}, \qquad (6)$$

wobei $\sigma_{20}$ die charakteristische Breite des Gauß-Profils angibt. Die Abbildungsfunktion L(y) wiederum ist näherungsweise eine Faltung einer Einzelabbildungsfunktion $\ell$(y) für eine einzelne Linse 16 und einer periodischen Gitterfunktion g(y) entsprechend der periodischen Anordnung der Linsen 16 in (dem entsprechenden Abschnitt 10a, 10b bzw. 10c) der periodischen Linsenanordnung 10:

$$L = \ell * g \quad \text{mit} \quad g(y) = \sum_{j=0}^{J-1} \delta(y - bj). \qquad (7)$$

Somit ist die komplexwertige Amplitude $A_{10}$ nach den Gleichungen (5) und (7) gleich

$$A_{10} = A_{20} * \ell * g. \qquad (8)$$

Da das punktweise Produkt (.) und das Faltungsprodukt (*) unter Fourier-Transformation wechselseitig ineinander übergehen, gilt für die resultierende komplexe Amplitude $A_{14}$ im Beleuchtungsfeld 14:

$$A_{14}(x) = \tilde{A}_{10}(\frac{2\pi x}{\lambda f}) \quad \text{mit} \quad \tilde{A}_{10} = \tilde{A}_{20} \cdot \tilde{\ell} \cdot \tilde{g}. \qquad (9)$$

Dabei wird das Gauss-Profil $A_{20}(y)$ der Gleichung (6) eines einfallenden kohärenten Strahlenbündels 20a, 20b, 20c zu einem aufgeweiteten Gauss-Profil $\tilde{A}_{20}(x)$ gemäß

$$\tilde{A}_{20}(\frac{2\pi x}{\lambda f}) \propto e^{-(x/\sigma_{10})^2} \quad \text{mit} \quad \sigma_{10} = \lambda f/(\sigma_{20}\,\pi), \qquad (10)$$

aus dem die Fourier-transformierte Einzetabbiidungsfunktion $\ell$ ein annähernd rechteckiges Intensitätsprofil herausschneidet. Jedoch ist gemäß Gleichung (9) diesem Rechteckprofil eine Gitterbeugungsfunktion $\tilde{g}$ multiplikativ überlagert. Die Gitterbeugungsfunktion $\tilde{g}$ kann durch Fourier-Transformation der periodischen Gitterfunktion g(y) der Gleichung (7) erhalten werden und ist dem Fachmann auf dem Gebiet der Optik wohlbekannt als

$$\tilde{g}(\frac{2\pi x}{\lambda f}) \propto \sin(Jx\frac{\pi b}{\lambda f})/\sin(x\frac{\pi b}{\lambda f}). \qquad (11)$$

In Gleichung (11) stehen als Parameter der Vorrichtung 300, 400 (bzw. eines Verwendungsverfahrens der Vorrichtung 300, 400) die Brennweite f des Kondensors 12, 32, die Wellenlänge $\lambda$ der einfallenden kohärenten Strahlenbündel 20a, 20b, 20c, die Anzahl J von jeweils einem der Strahlenbündel 20a, 20b, 20c beleuchteten Linsen 16 in (einem der Abschnitte 10a, 10b, 10c) der periodischen Linsenanordnung 10 und die Gitterperiodizität b der Linsenanordnung 10.

Wie eingangs erwähnt, ist die Intensität I(x) der Lichtstrahlung am Beleuchtungsschirm 14 dem Betragsquadrat

$$I(x) \propto |A_{14}(x)|^2$$

der komplexwertigen Amplitude $A_{14}$ proportional. Aus diesem Grund trägt jedes einzelne, in sich kohärente Strahlenbündel 20a, 20b, 20c mit einer Intensitätsmodulation 30a, 30b, 30c zur Beleuchtung des Beleuchtungsfelds 14 gemäß

$$I_k(x) \approx I_{36} \frac{2}{N} \sin^2(\frac{x}{P} - k\,V) \quad \text{mit} \quad P = \frac{\pi\,J\,b}{f\,\lambda} \qquad (12)$$

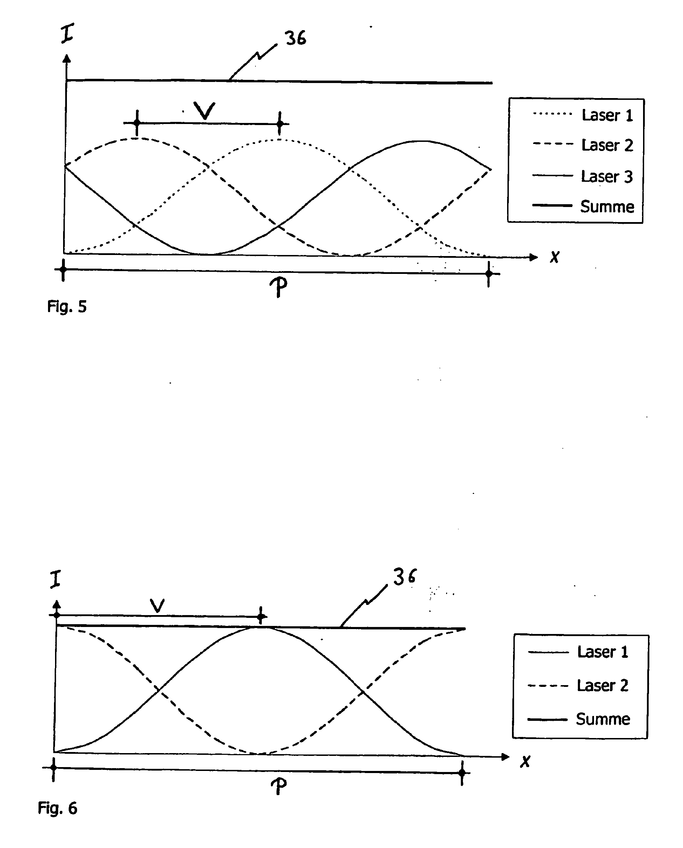

zur Gesamtintensität $I_{36}$ bei. In Gleichung (12) bezeichnet der Index k in der Intensitätsfunktion $I_k(x)$ die einzelnen Strahlenbündel 20a, 20b, 20c in einer Nummerierung k=0, 1, 2. Die einzelnen Strahlenbündel 20a, 20b, 20c sind um einen Versatz V gemäß Gleichung (12) lateral, d.h. in der in den Fign. 3 und 4 gezeigten x-Richtung, gegeneinander verschoben. Die Periodizität P der Interferenzmodulationen 30a, 30b, 30c <u>ist</u> gemäß Gleichung (12) ebenfalls bestimmt. Eine bevorzugte Wahl des Versatzes V ist

$$V = \frac{P}{N}, \qquad (13)$$

wobei N die Anzahl der lateral versetzt abgebildeten, jeweils für sich kohärenten Strahlenbündel 20a, 20b, 20c ist. Wie in den Fign. 5 und 6 für N = 3 bzw. N = 2 gezeigt, führt diese Wahl (zumindest unter den vorstehend gemachten Näherungen und Annahmen) zu einer in der Praxis im Wesentlichen gleichförmigen Verteilung der Gesamtintensität 36. Grund hierfür ist, dass es nicht zur Interferenz zwischen den paarweise inkohärenten Strahlenbündeln 20a, 20b, 20c kommt, sondern sich deren Intensitäten $I_k(x)$ additiv überlagern:

$$\sum_{k=0}^{N-1} I_k(x) \approx I_{36}. \qquad (14)$$

Tendenziell beleuchten die Vorrichtungen 300, 400 in der Praxis das Beleuchtungsfelds 14 umso homogener, je höher die Anzahl N der zueinander paarweise inkohärenten Strahlenbündel ist.

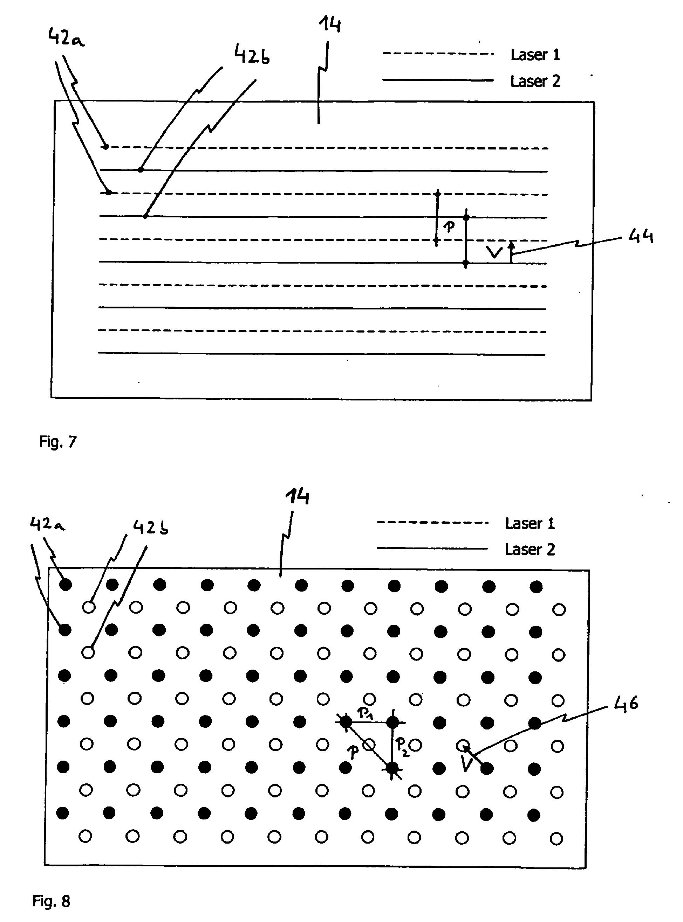

Die vorstehende Diskussion war auf eine eindimensionale laterale Strukturierung (in der x-Richtung) der Intensitätsmodulationen 30a, 30b, 30c gerichtet. Dies ist beispielsweise der Fall, wenn die einzelnen Linsen 16 der periodischen Linsenanordnung 10 Zylinderlinsen sind, welche senkrecht zur Bildebene der Fign. 3 bzw. 4 stehen. Hierzu zeigt Fig. 7 schematisch einzelne Intensitätsmaxima 42a und 42b für N = 2 Strahlenbündel 20a und 20b. In diesem Fall wird ein Versatz V in eine Richtung 44, hier die x-Richtung, gewählt.

Fig. 8 zeigt eine zweidimensionale Struktur der Intensitätsmodulationen 30a, 30b mit Maxima 42a bzw. 42b entsprechend der N = 2 kohärenten Strahlenbündeln 20a, 20b. In diesem Fall sind die Intensitätsmodulationen um einen Versatz V in Richtung 46 verschoben anzuordnen. Bei dem Richtungsvektor 46 handelt es sich um den N-ten Bruchteil eines dem Fachmann auf dem Gebiet der Optik bekannten sog. reziproken Gittervektors. Eine Verallgemeinerung der beschriebenen Vorrichtung zu einer beliebigen periodischen Linsenanordnung 10 der einzelnen Linsen 16 mit resultierendem reziproken Gitter 42a, 42b ergibt sich somit für den Fachmann unmittelbar.

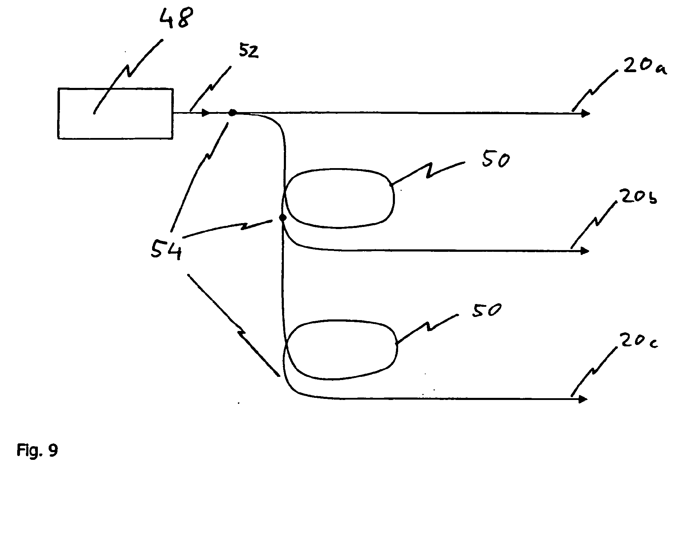

Wie vorstehend mehrfach betont, gehen die Vorrichtungen 300 bzw. 400 von mehreren jeweils in sich kohärenten und zueinander paarweise inkohärenten Strahlenbündeln 20a, 20b, 20c aus. Diese können jeweils durch einen eigenen (nicht phasengekoppelten) Laser erzeugt werden. Ergänzend oder alternativ dazu können einzelne oder alle Strahlenbündel 20a, 20b, 20c auch mittels einem oder wenigen Lasern erzeugt werden. Fig. 9 zeigt dazu eine Anordnung mit einem Laser 48 und einem Lichtleiter 50, in den vom Lasers 48 emittierte Laserstrahlung 52 eingespeist wird. An Punkten 54 werden die Strahlenbündel 20a, 20b, 20c ausgekoppelt. Die Strahlenbündel 20a, 20b, 20c sind in sich kohärent mit einer Kohärenzlänge in Abhängigkeit von einer Bauart des Lasers 48. Die Strahlenbündel 20a, 20b, 20c sind zueinander paarweise inkohärent, da die Auskopplungspunkte 54 so gewählt wurden, dass eine optische Weglänge im Lichtleiter 50 zwischen benachbarten Auskopplungspunkten 54 länger ist als die Kohärenzlänge.

Wie aus den vorstehenden Beschreibungen einzelner Ausführungsbeispiele klar geworden ist, kann mit der Vorrichtung 300 oder der Vorrichtung 400 einfallendes kohärentes Licht mit einem inhomogenen Strahlprofil homogenisiert, d.h. mit einer gleichmäßigen lateralen Intensitätsverteilung auf ein Beleuchtungsfeld 14 abgebildet werden, wobei es gleichzeitig gelungen ist, störende Interferenzmodulationen 30a, 30b, 30c aufgrund von Beugungseffekten an der periodischen Linsenanordnung 10 erfolgreich zu reduzieren.

**Bezugszeichenliste**

| | |
|---|---|
| 100 | Linsensystem gemäß Stand der Technik |
| 200 | erste Weiterbildung eines Linsensystems |
| 300, 400 | Vorrichtung gemäß Erfindung |
| 10 | periodische Linsenanordnung |
| 12 | Kondensator |
| 14 | Beleuchtungsfeld |
| 16 | Sammellinsen |
| 18 | Ausbreitungsrichtung einfallender Strahlung |
| 20, 20a, 20b, 20c | kohärentes Strahlenbündel |
| 22, 24 | Teilstrahlenbündel |
| 26 | Fokuspunkt |
| 28 | Kondensorlinse |
| 30, 30a, 30b, 30c | Intensitätsmodulationen |
| 32 | geteilte Kondensorlinse |
| 36 | Gesamtintensität |
| 38 | Drehrichtung |
| 40a, 40b | planparallele Platten |
| 42a, 42b | Interferenzmaxima |
| 44, 46 | Versatzvektor für 1D bzw. 2D |
| 48 | Laser |
| 50 | Lichtleiter |
| 52 | emittierte Laserstrahlung |
| 54 | Auskopplungspunkte |

**Patentansprüche**

1.  Vorrichtung (300; 400) zum Erzeugen homogenisierter Lichtstrahlung (20), wobei die Vorrichtung eine oder mehrere Lichtquellen umfasst, die Lichtstrahlung emittieren, die eine vorgegebene Wellenlänge und mehrere Strahlenbündel (20a, 20b, 20c) aufweist, die in sich kohärent und zueinander paarweise inkohärent sind, wobei die Vorrichtung des weiteren umfasst:

    - eine periodische Linsenanordnung (10), die mehrere Linsen (16) in wenigstens einer Ebene umfasst, die im Wesentlichen senkrecht zu einer Einfallsrichtung (18) der Lichtstrahlung (20) steht und
    - einen Kondensor (12), der angeordnet ist, von der periodischen Linsenanordnung (10) ausgehende Strahlen in ein in einem einer Brennweite (f) des Kondensors (12) entsprechenden Abstand angeordnetes Beleuchtungsfeld (14) abzubilden,

    wobei die Lichtstrahlung so gewählt ist, dass es für jedes der Strahlenbündel im Beleuchtungsfeld zu einer periodischen Modulation der Intensität kommt,
    die periodische Linsenanordnung (10) mehrere Abschnitte (10a, 10b, 10c) zum Einfall jeweils eines der mehreren Strahlenbündel (20a, 20b, 20c) mit der vorgegebenen Wellenlänge aufweist und in den Abschnitten periodisch bezüglich der Linsen (16) ausgebildet ist, und der Kondensor (12) ausgebildet ist,

die mehreren Strahlenbündel (20a, 20b, 20c) mit einem lateralen Versatz (V) auf das Beleuchtungsfeld (14) abzubilden, **dadurch gekennzeichnet, dass** der Versatz bemessen ist, durch Beugung der mehreren Strahlenbündel (20a, 20b, 20c) an der periodischen Linsenanordnung (10) verursachte Intensitätsmodulationen (30a, 30b, 30c) wechselseitig im Wesentlichen zu kompensieren.

2. Vorrichtung nach Anspruch 1, bei der die mehreren Abschnitte (10a, 10b, 10c) der periodischen Linsenanordnung (10) lateral beabstandet sind.

3. Vorrichtung nach Anspruch 1 oder 2, bei der durch Beugung verursachte Intensitätsmodulationen (30a, 30b, 30c) eine laterale Periodizität P aufweisen und der laterale Versatz (V) im Wesentlichen gleich P/N ist, wobei N die Anzahl der mehreren Strahlenbündel (20a, 20b, 20c) ist.

4. Vorrichtung nach einem der Ansprüche 1 bis 3, bei der der Kondensor (12) wenigstens eine in mehrere Teile (32a, 32b, 32c) unterteilte Kondensorlinse (32) umfasst und jeder Teil (32a, 32b, 32c) zum versetzten Abbilden je eines der mehreren Strahlenbündel (20a, 20b, 20c) angeordnet ist.

5. Vorrichtung nach Anspruch 4, bei der die Teile (32a, 32b, 32c) der unterteilten Kondensorlinse (32) lateral beabstandet sind und/oder zueinander geneigt stehen.

6. Vorrichtung nach einem der Ansprüche 1 bis 3, bei der im Strahlengang einer Teilzahl der mehreren Strahlenbündel (20a, 20b, 20c) jeweils eine planparallele Platte (40a, 40b) hinter dem Kondensor (12) angeordnet ist.

7. Vorrichtung nach Anspruch 6, bei der die planparallelen Platten (40a, 40b) zueinander geneigt stehen.

8. Vorrichtung nach einem der vorhergehenden Ansprüche, mehrere Lichtquellen umfassend, wobei jede Lichtquelle ausgebildet ist, jeweils einen der mehreren Strahlenbündel (20a, 20b, 20c) zu erzeugen.

9. Vorrichtung nach Anspruch 8 mit Lasern und/oder Laserdioden oder mit frequenzverdoppelten Festkörperlasern als die Lichtquellen.

10. Vorrichtung nach einem der Ansprüche 1 bis 7, ferner einen Lichtleiter (50) zur Aufnahme der Lichtstrahlung (20) umfassend, wobei der Lichtleiter (50) Auskopplungspunkte (54) umfasst jeweils zum Auskoppeln eines der mehreren Strahlenbündel (20a, 20b, 20c) und optische Weglängen zwischen den Auskopplungspunkten (54) größer sind als eine Kohärenzlänge der Lichtstrahlung (20).

11. Vorrichtung nach einem der vorhergehenden Ansprüche, bei der der Kondensor (12) zumindest eine Sammellinse umfasst.

**Claims**

1. A device (300; 400) for generating homogenized light radiation (20), wherein the device comprises one or a plurality of light sources emitting light radiation which has a predetermined wavelength and multiple ray beams (20a, 20b, 20c) that are coherent in themselves and, in pairs, incoherent relative to one another, wherein the device additionally comprises:

   - a periodic lens arrangement (10) comprising multiple lenses (16) in at least one plane extending substantially perpendicular to an incidence direction (18) of the light radiation (20), and
   - a condenser (12) arranged for imaging rays that emanate from the periodic lens arrangement (10) in an illumination field (14) arranged at a distance that corresponds to the focal length (f) of the condenser (12), wherein the light radiation is chosen such that a periodic modulation of intensity occurs for each ray beam in the illumination field, the periodic lens arrangement (10) has multiple sections (10a, 10b, 10c) for incidence of a respective one of the multiple ray beams (20a, 20b, 20c) with the predetermined wavelength and is formed periodically with respect to the lenses (16) in said sections, and the condenser (12) is configured to image the multiple ray beams (20a, 20b, 20c) with a lateral displacement (V) onto the illumination field (14), **characterized in that** the displacement is dimensioned for substantial mutual compensation of the intensity modulations (30a, 30b, 30c) caused by diffraction of the multiple ray beams (20a, 20b, 20c) on the periodic lens arrangement (10).

**2.** The device according to claim 1, wherein the multiple sections (10a, 10b, 10c) of the periodic lens arrangement (10) are laterally spaced.

**3.** The device according to claim 1 or 2, wherein intensity modulations (30a, 30b, 30c) caused by diffraction have a lateral periodicity P and the lateral displacement (V) is substantially equal to P/N, wherein N is the number of multiple ray beams (20a, 20b, 20c).

**4.** The device according to one of the claims 1 to 3, wherein the condenser (12) comprises at least one condenser lens (32) subdivided into multiple parts (32a, 32b, 32c) and each part (32a, 32b, 32c) is arranged for displaced imaging of a respective one of the multiple ray beams (20a, 20b, 20c).

**5.** The device according to claim 4, wherein the parts (32a, 32b, 32c) of the subdivided condenser lens (32) are laterally spaced from one another and/or inclined relative to one another.

**6.** The device according to one of the claims 1 to 3, wherein in the ray path of a part of the multiple ray beams (20a, 20b, 20c) there is a respective plane-parallel plate (40a, 40b) arranged behind the condenser (12).

**7.** The device according to claim 6, wherein the plane-parallel plates (40a, 40b) are inclined relative to one another.

**8.** The device according to one of the preceding claims, comprising a plurality of light sources, each light source being configured to generate a respective one of the multiple ray beams (20a, 20b, 20c).

**9.** The device according to claim 8, comprising lasers and/or laser diodes or comprising frequency-doubled solid state lasers as the light sources.

**10.** The device according to one of the claims 1 to 7, further comprising a light guide (50) for receiving the light radiation (20), wherein the light guide (50) comprises outcoupling points (54) each used for coupling out one of the multiple ray beams (20a, 20b, 20c), and wherein optical path lengths between the outcoupling points (54) are longer than a coherence length of the light radiation (20).

**11.** The device according to one of the preceding claims, wherein the condenser (12) comprises at least one converging lens.

## Revendications

**1.** Dispositif (300 ; 400) pour produire un rayonnement lumineux (20) homogénéisé, le dispositif comportant une ou plusieurs sources lumineuses qui émettent un rayonnement lumineux présentant une longueur d'onde prédéfinie et plusieurs faisceaux de rayons (20a, 20b, 20c) cohérents en soi et mutuellement incohérents par paire, ie dispositif comportant en outre :

- un agencement de lentilles (10) périodique comprenant plusieurs lentilles (16) dans au moins un plan qui se trouve dans une position sensiblement perpendiculaire à une direction d'incidence (18) du rayonnement lumineux (20), et
- un condenseur optique (12) disposé pour reproduire une image des rayons issus de l'agencement de lentilles (10) périodique dans un champ d'éclairement (14) agencé à une distance correspondant à une distance focale (f) du condenseur optique (12),
dans lequel le rayonnement lumineux est choisi de manière à ce qu'il se produise une modulation périodique de l'intensité pour chacun des faisceaux de rayons dans le champ d'éclairement, dans lequel l'agencement de lentilles (10) périodique présente plusieurs tronçons (10a, 10b, 10c) pour l'incidence respective de l'un des plusieurs faisceaux de rayons (20a, 20b, 20c) avec la longueur d'onde prédéfinie, et est réalisé, dans les tronçons, selon une configuration périodique quant aux lentilles (16), et dans lequel le condenseur optique (12) est conçu pour reproduire une image des plusieurs faisceaux de rayons (20a, 20b, 20c) avec un décalage latéral (V) sur le champ d'éclairement (14),
**caractérisé en ce que** le décalage est dimensionné pour sensiblement compenser réciproquement des modulations d'intensité (30a, 30b, 30c) occasionnées par diffraction des plusieurs faisceaux de rayons (20a, 20b, 20c) au niveau de l'agencement de lentilles (10) périodique.

**2.** Dispositif selon la revendication 1, dans lequel les plusieurs tronçons (10a, 10b, 10c) de l'agencement de lentilles (10) périodique sont espacés latéralement.

**3.** Dispositif selon la revendication 1 ou la revendication 2, dans lequel des modulations d'intensité (30a, 30b, 30c) occasionnées par diffraction présentent une périodicité latérale P, et le décalage latéral (V) est sensiblement égal à P/N, N étant le nombre des plusieurs faisceaux de rayons (20a, 20b, 20c).

**4.** Dispositif selon l'une des revendications 1 à 3, dans lequel le condenseur optique (12) comprend au moins une lentille de condenseur optique (32) subdivisée en plusieurs parties (32a, 32b, 32c), et chaque partie (32a, 32b, 32c) est agencée pour reproduire respectivement de manière décalée une image de l'un des plusieurs faisceaux de rayons (20a, 20b, 20c).

**5.** Dispositif selon la revendication 4, dans lequel les parties (32a, 32b, 32c) de la lentille de condenseur optique (32) sont espacées latéralement et/ou inclinées les unes par rapport aux autres.

**6.** Dispositif selon l'une des revendications 1 à 3, dans lequel une lame à faces parallèles (40a, 40b) est agencée respectivement sur le trajectoire des rayons d'un nombre partiel des plusieurs faisceaux de rayons (20a, 20b, 20c) derrière le condenseur optique (12).

**7.** Dispositif selon la revendication 6, dans lequel les lames à faces parallèles (40a, 40b) sont inclinées l'une par rapport à l'autre.

**8.** Dispositif selon l'une des revendications précédentes, comprenant plusieurs sources lumineuses, dans lequel chaque source lumineuse est conçue pour engendrer respectivement l'un des plusieurs faisceaux de rayons (20a, 20b, 20c).

**9.** Dispositif selon la revendication 8, comprenant des lasers et/ou des diodes laser ou comprenant des lasers à corps solide à doublage de fréquence en tant que desdites sources lumineuses.

**10.** Dispositif selon l'une des revendications 1 à 7, comprenant en outre un guide d'ondes optique (50) destiné à recevoir le rayonnement lumineux (20), dispositif dans lequel le guide d'ondes optique (50) présente des points de découplage (54), chacun pour découpler l'un des plusieurs faisceaux de rayons (20a, 20b, 20c), et dans lequel des longueurs de trajectoire optiques entre les points de découplage (54) sont plus grandes qu'une longueur de cohérence du rayonnement lumineux (20).

**11.** Dispositif selon l'une des revendications précédentes, dans lequel le condenseur optique (12) comporte au moins une lentille convergente.

Fig. 1

Fig. 2

EP 2 237 079 B1

Fig. 3

Fig. 4

14

Fig. 5

Fig. 6

**Fig. 7**

**Fig. 8**

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4220705 C2
- DE 10225674 A1
- DE 19751106 A1

**In der Beschreibung aufgeführte Nicht-Patentliteratur**

- **DRUCKSCHRIFT.** *Photonik 3/2006,* Marz 2006, 76-79